# EUROPEAN PATENT APPLICATION

(11) **EP 1 777 551 A2**
(43) Date of publication of application: **25.04.2007**
(21) Application number: 06021524.1
(22) Date of filing: 13.10.2006
(51) Int. Cl.: G01S 13/93, G01S 7/03

(54) **Millimeter-wave radar apparatus and millimeter radar system**

(30) Priority: 18.10.2005 JP 2005302432
(71) Applicant: Hitachi, Ltd., Tokyo (JP)
(72) Inventor: Nagaishi, Hideyuki, c/o Hitachi, Ltd., IP Group, Chiyoda-ku, Tokyo 100-8220 (JP); Shinoda, Hiroshi, c/o Hitachi, Ltd., IP Group,, Chiyoda-ku, Tokyo 100-8220 (JP); Matsuura, Kazuo, c/o Hitachi, Ltd., IP Group,, Chiyoda-ku, Tokyo 100-8220 (JP)
(74) Representative: Beetz & Partner

(57) **Abstract**

The present invention relates to a millimeter-wave radar apparatus which has a good heat radiation characteristic. The apparatus includes a multilayer substrate (1), an RF circuit (2), an antenna (3), a thermal via hole (5), a heat transmitting plate (4), and a casing (6). The RF circuit (2) and the antenna (3) are provided on the front and rear surfaces of the multilayer substrate (1) respectively. The thermal via hole (5) is provided within the multilayer substrate (1). The heat transmitting plate (4) is formed therein with an opening so as to avoid deterioration of the wave radiation characteristic of the antenna (3). The plane of the antenna is contacted with the heat transmitting plate (4). Heat generated in an MMIC as an active circuit of the RF circuit (2) is transmitted through the thermal via hole (5) and laminated metallic layers, and is diffused onto the surface of the multilayer substrate (1). Heat reaching the antenna surface of the multilayer substrate (1) is radiated from the heat transmitting plate (4).

## Description

### BACKGROUND OF THE INVENTION

The present invention relates to millimeter-wave radar apparatuses which detects a distance from an object by receiving a reflection signal of a radiated electromagnetic wave of a millimeter-wave band reflected by the object and a millimeter-wave radar systems using the apparatuses, and more particularly, to a near-field millimeter-wave radar apparatus which observes an object present at a position away by a short distance from a vehicle and a millimeter-wave radar system using the apparatus.

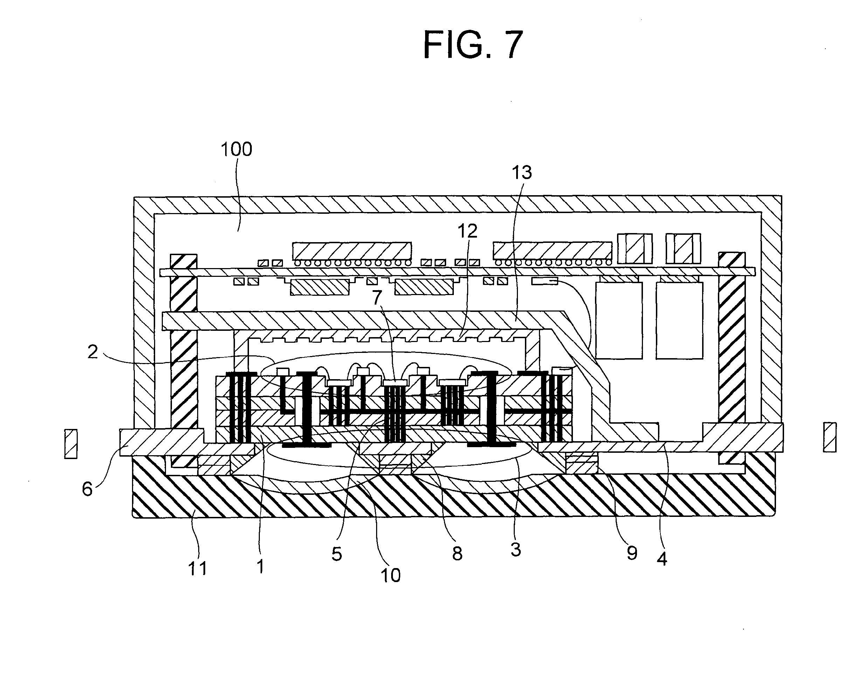

A related microwave/millimeter-wave apparatus, for the purpose of obtaining its small size and low cost, is arranged so that a planar antenna is provided on the rear surface of a dielectric substrate (refer to JP-A-11-330163). More specifically, in FIG. 18 of JP-A-11-330163, a planar antenna 141 is provided on the rear surface of a dielectric substrate 1, and a semiconductor substrate 2 is provided on the front surface of the dielectric substrate 1 with metallic bumps disposed therebetween. In JP-A-11-330163, further, as an arrangement of radiating heat from an active circuit on the semiconductor substrate 2, there is disclosed an arrangement wherein a conductor 71 is provided on the rear surface of the semiconductor substrate 2 so that heat generated in the active circuit positioned on the front surface of the semiconductor substrate 2 is transmitted to the conductor 71 on the rear surface of the semiconductor via a through hole passed through the front and rear surfaces of the semiconductor substrate 2 to radiate the heat through the conductor 71 and to provide a good heat radiating performance to an active element, as shown in FIG. 7(b).

An example of related antenna integrated microwave-millimeter wave circuits has an arrangement wherein a metallic base for radiating heat to the periphery of a dielectric substrate (for example, refer to JP-A-10-233621). More specifically, in FIG. 6 of JP-A-10-233621, a microstrip antenna is made of a radiating conductor 553 and a ground conductor 552 and a metallic base 560 for reinforcement and heat radiation is provided around a dielectric substrate 551 to be electrically connected to the ground conductor 552.

The inventor, et al. of this application has studied microwave-millimeter wave radar techniques prior to this application. Use of a high frequency circuit module of microwave-millimeter wave is increasingly expanded as a module for transmitting and receiving a high frequency signal for a car-mounted radar or inter-car communication. For detecting an obstacle around a vehicle with a wide angle, a car-mounting near-field radar, in particular, is desired to be mounted at various positions such as the interiors of vehicle bumper, lamp and door mirror. However, the operation of the high frequency circuit module for car mounting is required to be ensured in a temperature range of from minus tens of degrees (e.g., about -40 degrees) to plus hundred and tens of degrees (e.g., about +110 degrees). When the high frequency circuit module is installed within such a closed space tending to have heat confined therein as the interior of bumper, lamp or door mirror, the high frequency circuit module is required to satisfy severe specifications to a temperature environment. With the arrangement of the high frequency circuit module, when it is impossible to realize an embodiment arranged to suppress a thermal resistance, a difference in temperature between the ensured-operation range of the high frequency circuit module and a temperature outside the apparatus becomes large. In particular, when the temperature outside the apparatus is high, the operation of active circuit becomes out of the operation-ensured temperature range, so that the high frequency circuit module is erroneously operated. In the case of the car-mounted radar, since the radar is treated as a sensor in a vehicle control device, the erroneous operation of the high frequency device leads to a delay in accident avoidance and thus a measure of heat radiation in the high frequency device is highly important. Further, since the bumper, lamp, or door mirror of a vehicle has a small limited space, the car-mounted radar is required not only to take the aforementioned heat radiation measure but also to have a small size. The exemplary arrangements of such a related device as to take the heat radiation measure are disclosed in JP-A-11-330163 and JP-A-10-233621.

In the case of the heat radiation arrangement having a conductor provided on the rear surface of a semiconductor substrate as shown in JP-A-11-330163, however, heat from the conductor is further required to be escaped to outside the device. To this end, a means for externally escaping heat from the conductor is additionally required, for example, by further providing a fin on the conductor. From it, the inventor, et al. of this application have uniquely found a disadvantageous problem when the device is made small in size.

In addition, in the case of such an arrangement as shown in JP-A-10-233621, a ground conductor and a metallic base for contributing to heat radiation in a microstrip antenna are disposed to be mutually overlapped. Thus the inventor, et al. of this application have uniquely found a problem that, when an electromagnetic wave is radiated from the microstrip antenna to outside an antenna integration millimeter-wave circuit, the metallic base disturbs the heat radiation, thus involving the deterioration of an electric wave radiation characteristic.

### SUMMARY OF THE INVENTION

A typical embodiment of the present invention as an example is as follows. That is, in accordance with an aspect of the present invention, there is provided a millimeter-wave radar apparatus which includes a multilayer substrate made of a plurality of stacked layers, an active circuit provided on a first surface of the multilayer substrate; an antenna provided on a second surface of the multilayer substrate opposed to the first surface thereof for radiating an electric signal of millimeter-wave generated by the active circuit in the form of an electromagnetic wave, and/or a first heat transmitting plate provided on the second surface for externally radiating heat generated in the active circuit. The antenna is electrically connected with the active circuit via a first via hole formed to pass through at least part of the multilayer substrate defined by the first and second surfaces of the multilayer substrate when viewed as A.C. circuit. The heat transmitting plate is formed to pass through at least part of the multilayer substrate defined by the first and second surfaces thereof, and also is thermally connected with the active circuit via a second via hole formed as a via hole different from the first via hole.

The present invention provides a millimeter-wave radar apparatus which realizes compatibility between an improvement in the heat radiation characteristic of the apparatus and an improvement in the electronic wave radiation characteristic thereof.

Other objects, features and advantages of the invention will become apparent from the following description of the embodiments of the invention taken in conjunction with the accompanying drawings.

The above features may be combined in any way, partly or as a whole.

### BRIEF DESCRIPTION OF THE DRAWINGS

FIG. 1 shows a millimeter-wave radar apparatus in accordance with a first embodiment of the present invention;
FIG. 2 is a perspective view of a multilayer substrate in the millimeter-wave radar apparatus of the first embodiment of the invention on a side (first surface) of the multilayer substrate formed with an active circuit thereon;
FIG. 3 shows a millimeter-wave radar apparatus in accordance with a second embodiment of the present invention;
FIG. 4 is a perspective view of a multilayer substrate in the millimeter-wave radar apparatus of the second embodiment of the invention on a side (first surface) of the multilayer substrate formed with an active circuit;
FIG. 5 shows a millimeter-wave radar apparatus in accordance with a third embodiment of the present invention;
FIG. 6 shows a millimeter-wave radar apparatus in accordance with a fourth embodiment of the present invention;
FIG. 7 shows a millimeter-wave radar apparatus in accordance with a fifth embodiment of the present invention;
FIG. 8 shows a millimeter-wave radar apparatus in accordance with a sixth embodiment of the present invention;
FIG. 9 is a block diagram of the millimeter-wave radar apparatus of the present invention;
FIG. 10 shows a connection relation between an RF circuit and an antenna in the millimeter-wave radar apparatus of the present invention;
FIG. 11 shows a first example of the multilayer substrate in the millimeter-wave radar apparatus of the present invention;
FIG. 12 shows a structure of a pseudo coaxial line used in the millimeter-wave radar apparatus of the present invention;
FIG. 13 shows a second example of the multilayer substrate in the millimeter-wave radar apparatus of the present invention;
FIG. 14 shows a general arrangement of a millimeter-wave radar system in accordance with an embodiment of the present invention;
FIG. 15 is a block diagram of the millimeter-wave radar system of the invention;

FIG. 16 is a plan view of a side of the multilayer substrate having the antenna formed thereon in the millimeter-wave radar apparatus of the third-to-sixth embodiments of the invention; and

FIG. 17 an exploded perspective view of respective members included in the plan view of FIG. 16.

### DETAILED DESCRIPTION OF THE EMBODIMENTS

A millimeter-wave radar apparatus in accordance with the present invention includes a multilayer substrate, an active circuit, an antenna, a thermal via hole, and a heat transmitting plate. The active circuit is realized preferably as an active element in an RF circuit. The apparatus also includes a casing for fixing the entire millimeter-wave radar apparatus to a vehicle or the like. The RF circuit and the antenna are provided on the front and rear surfaces (or first and second surfaces) of the multilayer substrate respectively, and a plurality of thermal via holes are provided in the interior of the multilayer substrate. The heat transmitting plate formed on the second surface is formed therein with an opening which acts not to deteriorate the radiation characteristic of the antenna formed on the same second surface. Heat generated in an MMIC (Monolithic Microwave Integrated Circuit) as an example of the active element of the RF circuit is transmitted through the thermal via hole and the laminated metallic layer and diffused on the surfaces of the multilayer substrate. Heat reaching the rear or second surface of the multilayer substrate is radiated from the heat transmitting plate provided on the second surface.

The thermal via hole is preferentially located under the MMIC mounted on the multilayer substrate. However, since especially the stable operation of an oscillator directly affects the performance of the radar, the oscillator is positioned on the multilayer substrate to be connected via the multilayer substrate to the heat transmitting plate with the shortest distance to the plate, thus reducing a thermal resistance. The heat transmitting plate is connected suitably to the casing of the millimeter-wave radar apparatus. However, the present invention is not limited to this example, but the casing may be formed integrally with the heat transmitting plate. Or the heat transmitting plate may be connected with the shortest distance to the mounting hole of the millimeter-wave radar apparatus, or the heat transmitting plate may form part of the casing and a hole for mounting the millimeter-wave radar apparatus may be provided in the heat transmitting plate. With such an arrangement, since a thermal resistance from the MMIC as the active circuit to the radar casing mounting hole is reduced, an increase in the operational temperature of the millimeter-wave radar apparatus can be suppressed. Thus, even the external environment temperature is high, the millimeter-wave radar apparatus can be operated continuously stably.

More specifically, a millimeter-wave radar apparatus of the present invention includes a multilayer substrate made of a plurality of overlapped layers, an active circuit provided on a first surface of the multilayer substrate, an antenna provided on a second surface of the multilayer substrate opposed to the first surface thereof for radiating a millimeter-wave electric signal generated in the active circuit in the form of an electromagnetic wave, and a first heat transmitting plate provided on the second surface for externally radiating heat generated in the active circuit. The antenna is electrically connected to the active circuit through a first via hole formed so as to pass through at least part of the multilayer substrate defined by the first and second surfaces thereof when viewed as an A.C. (Alternating Current) circuit. The heat transmitting plate is formed so as to pass through at least part of the multilayer substrate defined by the first and second surfaces thereof, and is also thermally connected to the active circuit through a second via hole formed as a via hole different from the first via hole.

In this case, the active circuit and the heat transmitting plate are located suitably so that heat generated in the active circuit is transmitted to the heat transmitting plate through the second via hole, with the shortest route thereto. The active circuit and the first heat transmitting plate are provided suitably so as to be thermally connected commonly by a plurality of such second via holes. Or suitably, the heat transmitting plate has such an opening as to externally expose the antenna, the antenna is located in a region of the second surface having the opening positioned therein, and a radio wave absorber is provided so as to straddle the opening of the heat transmitting plate and the other part thereof except for the opening. The radio wave absorber has suitably a tapered shape. The radio wave absorber is also made of preferably a material containing powder which absorbs electromagnetic wave. The material contains most preferably powder of at least one of sorts of carbon, graphite, silicon carbide, and carbon nanotube.

The millimeter-wave radar apparatus of the present invention further includes preferably a casing for fixing the multilayer substrate. In this case, the multilayer substrate may be fixed to the casing through the first heat transmitting plate so as to secure a heat radiation path to externally radiate heat from the heat transmitting plate through a plurality of holes provided in the casing. Alternatively the first heat transmitting plate and the casing may be integrally formed to secure a heat radiation path to externally radiate heat from the heat transmitting plate through a plurality of holes provided in the casing.

The first heat transmitting plate and the multilayer substrate are mutually bonded preferably using at least one of a heat transmitting adhesive, a conductive adhesive, flip-chip bonding, and an anisotropic adhesive. When the both are mutually bonded, in particular, by flip-flop bonding or with use of the anisotropic adhesive, the via hole is also used as an input/output terminal. The heat transmitting plate includes preferably a heat transmitting metallic conductor. Or the heat transmitting plate may be made of a material containing a resin. In this case, at least one of a signal processing circuit and a power supply circuit in the millimeter-wave radar apparatus is mounted preferably on the heat transmitting plate.

The millimeter-wave radar apparatus of the present invention further includes preferably a polarizer for suppressing the interference of cross polarized waves. In this case, the polarizer is provided preferably on a side of the multilayer substrate opposed to the radio wave absorber opposed to the multilayer substrate with the absorber disposed between the polarizer and the multilayer substrate. The millimeter-wave radar apparatus further includes preferably a radome which covers the entire multilayer substrate and is positioned on a side of the radio wave absorber opposed to the multilayer substrate with the absorber disposed between the multilayer substrate and the radome. In this case, the thickness of the radome is set to be preferably nearly equal to an integral multiple of λ/2, where λ denotes the wavelength of the electromagnetic wave radiated from the antenna. When the millimeter-wave radar apparatus of the present invention further includes a casing for fixing the multilayer substrate, the radome is preferably fixed to the casing.

In the millimeter-wave radar apparatus of the invention, the active circuit and the antenna are electrically connected by the microstrip line and the first via hole when viewed as an A.C. circuit, and the first via hole is a pseudo coaxial line which is made of a plurality of via holes passed through at least part of the multilayer substrate and acts as a pseudo coaxial line. When λ denotes the wavelength of the electromagnetic wave radiated from the antenna, a metallic conductive layer forming a counter electrode of the microstrip line is formed preferably in the form of a landless gap pattern with a gap of λ/4 from the via hole as the center conductor of the pseudo coaxial line.

A millimeter-wave radar system in accordance with the present invention includes a millimeter-wave radar apparatus arranged to be mounted in a vehicle. The millimeter-wave radar system is arranged to observe an obstacle to the vehicle. In this case, the millimeter-wave radar apparatus includes a multilayer substrate made of a plurality of overlapped layers, an active circuit provided on a first surface of the multilayer substrate, an antenna provided on a second surface of the multilayer substrate opposed to the first surface for radiating a millimeter-wave electric signal generated by the active circuit as an electromagnetic wave, and a first heat transmitting plate provided on the second surface for externally radiating heat in the active circuit. The antenna is electrically connected to the active circuit through a first via hole formed to pass through at least part of the multilayer substrate between the first and second surfaces thereof when viewed as an A.C. circuit. The heat transmitting plate is thermally connected to the active circuit through a second via hole different from the first via hole and formed to pass through at least part of the multilayer substrate between the first and second surfaces thereof. As in the aforementioned millimeter-wave radar apparatus, the active circuit and the heat transmitting plate are located to preferably transmit heat generated in the active circuit to the heat transmitting plate through the second via hole with the shortest route, and the active circuit and the first heat transmitting plate are preferably thermally connected commonly by a plurality of the second via holes.

The present invention will be explained in detail in connection with several embodiments as the preferred examples of embodying the present invention, by referring to the accompanying drawings.

### Embodiment 1:

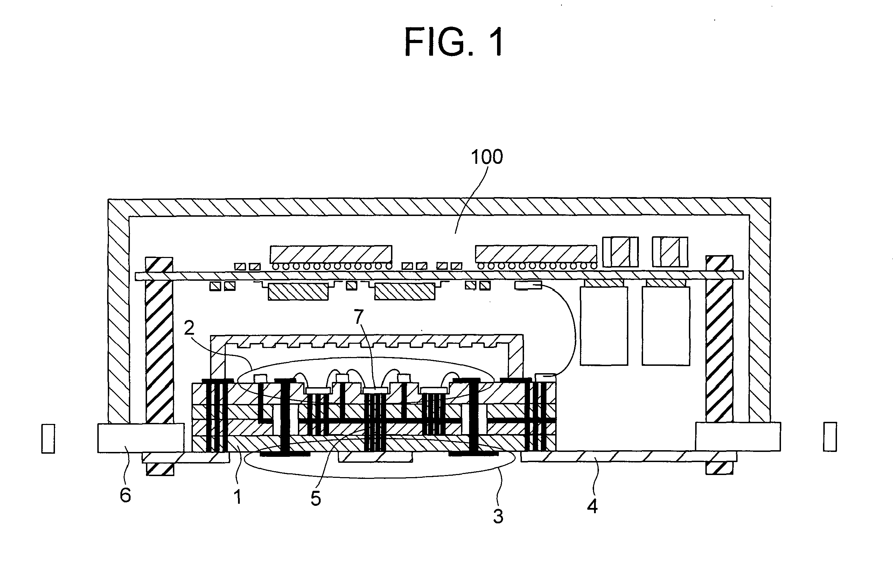

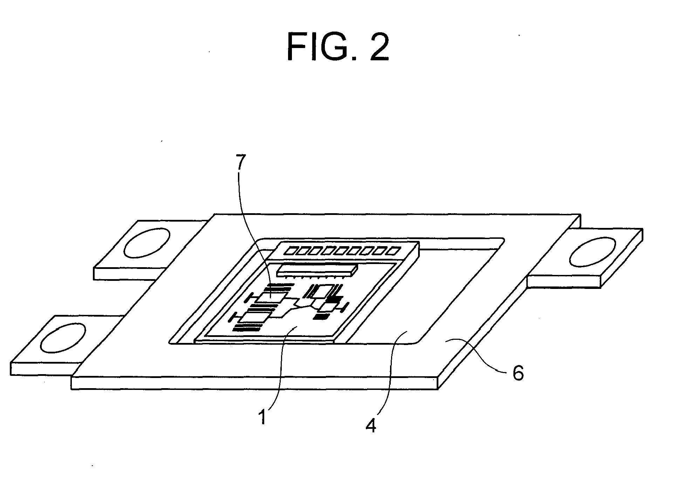

FIG. 1 shows a millimeter-wave radar 100 in accordance with a first embodiment of the present invention. FIG. 2 is a perspective view of a high frequency circuit module in the first embodiment of the present invention. The millimeter-wave radar 100 in present embodiment includes at least a multilayer substrate 1, an RF (Radio Frequency) circuit 2 mounted on a major surface of the multilayer substrate 1, an antenna 3 and a heat transmitting plate 4 mounted on a surface (rear surface) of the multilayer substrate 1 opposed to the major surface respectively, a via hole (heat conductor) 5 passed through the multilayer substrate 1 substantially vertically to the major surface of the multilayer substrate 1, a casing 6, and an active circuit 7 in the RF circuit 2. The active circuit 7 includes an oscillator 14, a power amplifier 15, and a power amplifier 16. The antenna 3 of the millimeter-wave radar 100, which actively observes, radiates an millimeter-wave from the antenna 3, again receives the electromagnetic wave reflected by an obstacle, and generates an IF (Intermediate Frequency) signal in the RF circuit 2. The RF circuit 2 including the active circuit 7 is formed in the surface layer of the multilayer substrate 1, and the antenna 3 is formed in the surface layer. The active circuit 7 is mounted on the multilayer substrate 1 as a pair chip with the circuit surface of the active circuit 7 up. The via hole (heat conductor) 5 is buried in the multilayer substrate 1 to connect the active circuit 7 and the heat transmitting plate 4. The active circuit 7 connected to the heat conductor 5 is mounted on a side of the multilayer substrate 1 opposed to the heat transmitting plate 4 via the multilayer substrate 1. Further, the heat transmitting plate 4 is mounted on the rear surface of the multilayer substrate 1 so as not to be overlapped with the antenna 3. For this reason, a distance between the active circuit 7 and the heat transmitting plate 4 can be made short while avoiding influences on the wave radiation characteristic of the antenna 3, and heat generated in active circuit 7 can be efficiently transmitted to the heat transmitting plate 4. Preferably, the active circuit 7 is positioned directly above the heat transmitting plate 4 with the multilayer substrate disposed therebetween, so that the RF circuit 2 and the heat transmitting plate 4 are connected via the heat conductor 5 made of a multiplicity of via holes passed through the multilayer substrate 1 vertically to the multilayer substrate. Heat generated by the operation of the active circuit 7 is propagated from the rear surface of the active circuit 7 opposed to its circuit surface to the heat transmitting plate 4. A multiplicity of the via holes 5 are buried in inner layers of the multilayer substrate 1 and are positioned to be concentrated under the active circuit 7. The via hole 5 has a metallic conductor having a thermal resistance smaller than the dielectric material of the multilayer substrate 1, and corresponds to the first member of a heat radiation path of the active circuit 7. The heat transmitting plate 4 is provided with an opening to avoid any interference with the wave radiation characteristic of the antenna 3. The heat transmitting plate 4 is connected to the multilayer substrate 1 so as not to be overlapped with the antenna 3. In order to realize the stable operation of the millimeter-wave radar 100, the active circuit 7 for the oscillator is positioned directly above the heat transmitting plate with the multilayer substrate 1 disposed between the active circuit 7 and the heat transmitting plate with the shortest distance thereto. The casing 6 has mounting holes for mounting the millimeter-wave radar 100, and is contacted with the heat transmitting plate 4. Accordingly, heat generated in the active circuit 7 is externally radiated from the via hole 5 of the multilayer substrate 1 through the heat transmitting plate 4, the casing 6, and the mount part of the casing 6.

A circuit for RF control is provided within the casing and above the multilayer substrate having the RF circuit board mounted thereon. The RF circuit and the RF control circuit are connected by a wire. In the arrangement of the present embodiment, since the RF control circuit and the RF circuit are vertically arranged into a row, the horizontal-direction width of the casing can be reduced.

Since the car-mounted radar handles a microwave or millimeter wave having a short wavelength, a small change in the length of the antenna caused by a temperature variation affects its radar characteristic. However, since the antenna and the heat transmitting plate are provided as separated members on one surface of the multilayer substrate in the present invention, heat generated in the active circuit is concentrated not on the antenna but on the heat radiating plate having a thermal resistance lower than the antenna. Thus, a change in the length of the antenna caused by a temperature variation affects the radar characteristic. Considering also the fact that the antenna characteristic is deteriorated by the thermal concentration on the antenna, the present invention proposes an arrangement of providing the antenna and the heat radiating plate as separated members.

Since millimeter wave has a large transmission line passage loss, it is necessary to minimize the length of a transmission line between the oscillator and the antenna. To this end, when the RF circuit and the antenna are mounted on the front and back surfaces of the multilayer substrate, the oscillator and the amplifiers in the RF circuit are positioned so as to minimize the length of the millimeter-wave transmission line. At the same time, however, it is also required to realize a heat radiation structure.

In the present invention, since a thin ceramic multilayer substrate is employed, it is advantageous to provide the heat radiating plate on the antenna side close in distance to the MMIC because of short wiring.

### Embodiment 2:

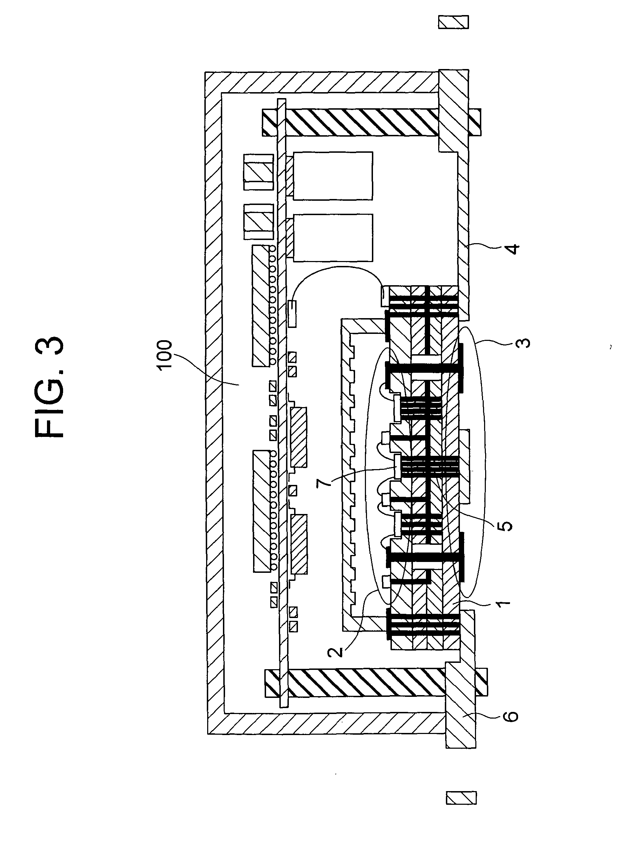

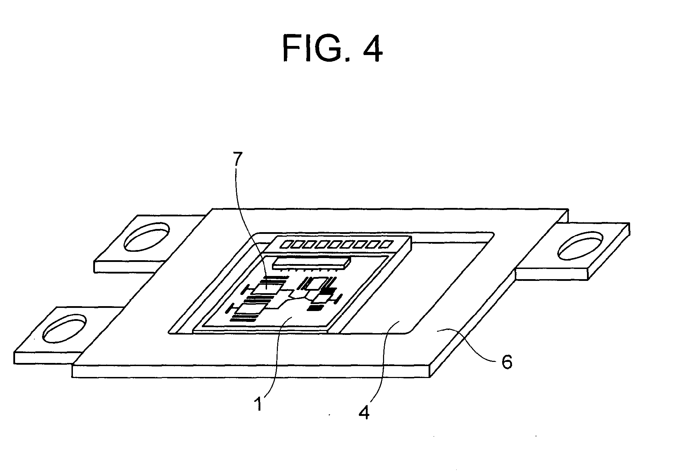

FIG. 3 shows a millimeter-wave radar 100 in accordance with a second embodiment of the present invention. FIG. 4 shows a perspective view of a high frequency circuit module in the second embodiment. The millimeter-wave radar 100 in the second embodiment is different from the millimeter-wave radar 100 in the first embodiment in that the heat transmitting plate 4 and the casing 6 are provided as a single integrated member. In the present embodiment, since the heat transmitting plate 4 and the casing 6 are provided not as physically separated members but as a single integrated member, no thermal resistance caused by a bonded surface between the heat transmitting plate 4 and the casing 6 is generated and thus the value of the thermal resistance as far as the mounting hole of the casing 6 can be lowered. This also is also valid for cost reduction caused by the member integration.

### Embodiment 3:

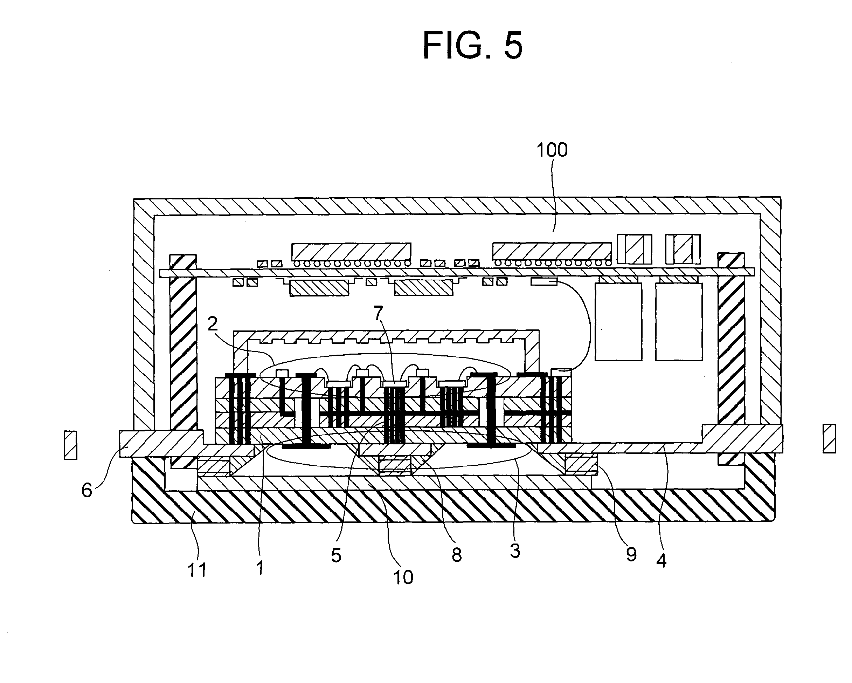

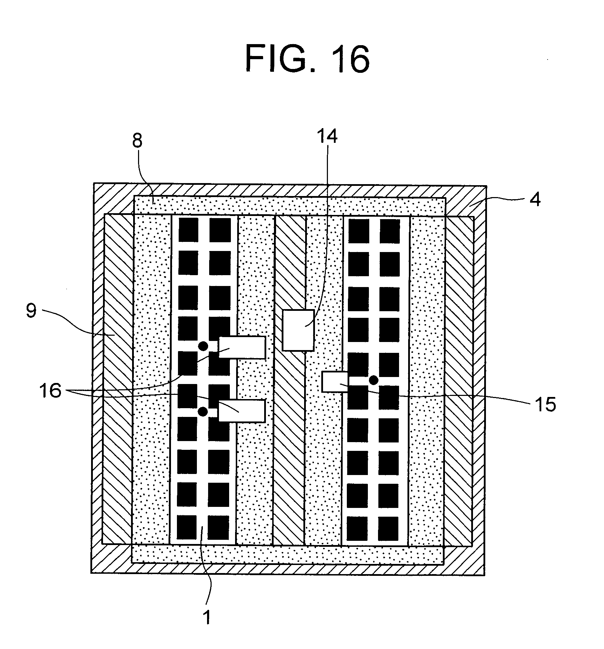

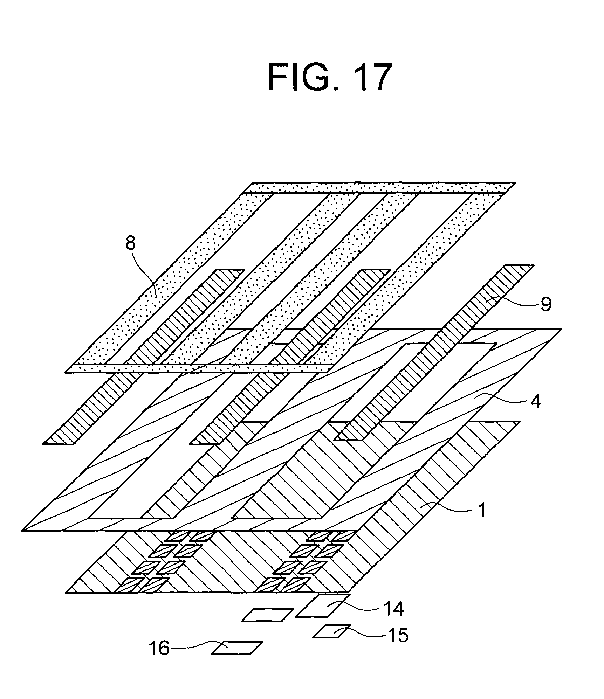

FIG. 5 shows a millimeter-wave radar 100 in accordance with a third embodiment of the present invention. FIGS. 16 and 17 show a plan view and an exploded perspective view of a surface (second surface) of millimeter-wave radar apparatuses of the third embodiment and fourth to sixth embodiments (to be explained later) having the antenna provided thereon respectively. The millimeter-wave radar 100 in the third embodiment is different from the millimeter-wave radar 100 in the second embodiment in that the radar of the third embodiment includes a radio wave absorber 8, a support base 9, a polarizer 10, and a radome 11. When the high frequency module is used as a millimeter-wave radar, a radar detection angle range can be broadened by increasing the angle range of an electromagnetic wave radiated from the antenna 3. When the radiation angle of the antenna 3 or a sidelobe (subbeam having a weak intensity radiated in directions different from its main beam) thereof is large or high, the radiation characteristic of the antenna 3 may be, in some cases, different from its desired characteristic due to the interference between the antennas or due to diffracted wave interference. In particular, a diffracted wave tends to be generated in the heat transmitting plate 4 close to the antenna 3. In the present embodiment, when the surface of the heat transmitting plate 4 is covered with the radio wave absorber 8, the generation of the diffracted wave can be suppressed. When the antenna 3 has a wide radiation angle characteristic, the radio wave absorber 8 is cut into a tapered member with an angle equal to or larger than the full width at half maximum of the antenna, considering the fact that the radio wave absorber 8 provided close thereto narrows the radiation characteristic. With this arrangement, the radio wave absorber 8 can be avoided from disturbing the radiation characteristic of the radio wave absorber 8. The radio wave absorber 8 is a sheet containing powder or a porous material for absorbing electromagnetic waves of micro-wave and millimeter-wave to increase a radio wave absorption performance. The powder includes carbon, graphite, hexagonal structure ferrite, silicon carbide, or carbon nanotube. When carbon or graphite power having a small specific heat is employed in the radio wave absorber, a good heat radiating effect can be expected due to the good heat transmission performance of the radio wave absorber. When silicon carbide is employed in the radio wave absorber, the absorber can advantageously have an excellent thermal producibility or moldability and suppress fluctuations in the electric characteristic of the radio wave absorber.

Further, the polarizer 10, which can advantageously suppress the orthogonal polarization of the antenna 3 and reduce the side lobe of the radiation characteristic, is located in front of the antenna. The support base 9 is provided to limit a distance between the polarizer 10 and the antenna 3. For securing the resistance to environment and reliability of the antenna 3, the radome 11 is provided in front of the antenna so as not to come into direct contact with its ambient environment. The thickness of the radome is set to an integral multiple of 1/2 of the electromagnetic wave radiated from the antenna 3 so as to allow the electromagnetic wave to be efficiently transmitted through the radome.

### Embodiment 4:

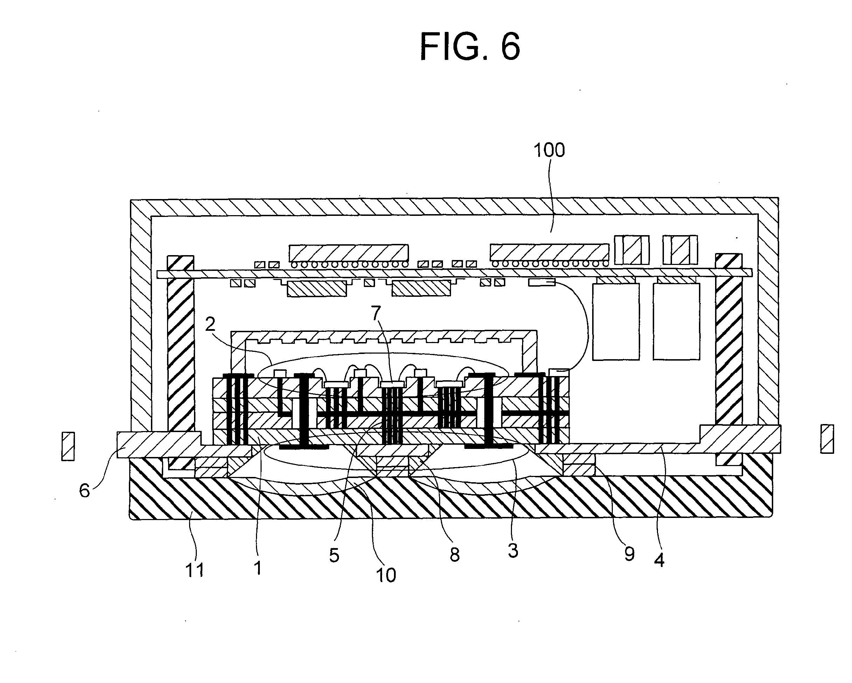

FIG. 6 shows a millimeter-wave radar 100 in accordance with a fourth embodiment of the present invention. The polarizer 10 of FIG. 5 used in the millimeter-wave radar is provided to be parallel to the plane of the antenna. The polarizer 10 in FIG. 6 is featured in that the plane of the polarizer is curved so as to have substantially an equal distance from the central position of the radio wave radiated from the antenna 3. The radome 11 can also be curved according to the shape of the polarizer 10. The polarizer is made of a metallic member to effectively suppress the orthogonal polarization. The polarizer is manufactured by pressing a thin film metallic substrate, by chemical etching, or by printing metallic conductive power on the radome 11. The radio wave absorber 8 shown in FIGS. 5 and 6 is made of a sheet containing powder or a porous material for absorbing electromagnetic waves of micro-wave and millimeter-wave to increase its wave absorbing performance. The power is of carbon, graphite, or hexagonal structure ferrite. When power of carbon or graphite having a small specific heat is used in the radio wave absorber, the radio wave absorber is expected to have a good heat radiating performance due to its good heat transmission ability.

### Embodiment 5:

FIG. 7 shows a millimeter-wave radar 100 in accordance with a fifth embodiment of the present invention. The millimeter-wave radar 100 of the present embodiment includes at least a multilayer substrate 1, an RF circuit 2, an antenna 3, a heat transmitting plate 4, a via hole 5, a casing 6, an active circuit 7 in the RF circuit, a radio wave absorber 8, a support base 9, a polarizer 10, a radome 11, an RF circuit lid 12, and a lid heat transmitting plate 13. Heat generated in the active circuit 7 is, as its main route, transmitted from the via hole 5 of the multilayer substrate 1 through the heat transmitting plate 4 and the casing 6 to the mount part of the casing 6, from which heat is externally radiated. The RF circuit lid 12 cannot be connected to the via hole 5 directly contacted with the active circuit 7, but can be connected to the via hole 5 provided in the surface layer of the multilayer substrate 1. For the purpose of diffusing heat staying in the multilayer substrate, a multiplicity of the via holes 5 are positioned even in the periphery of the RF circuit of the multilayer substrate 1. Accordingly, heat is propagated from the RF circuit lid 12 through the lid heat transmitting plate 13, the heat transmitting plate 4 to the casing 6. A thermal resistance between the active circuit 7 and the mounting hole of the casing 6 is expected to be further reduced.

### Embodiment 6:

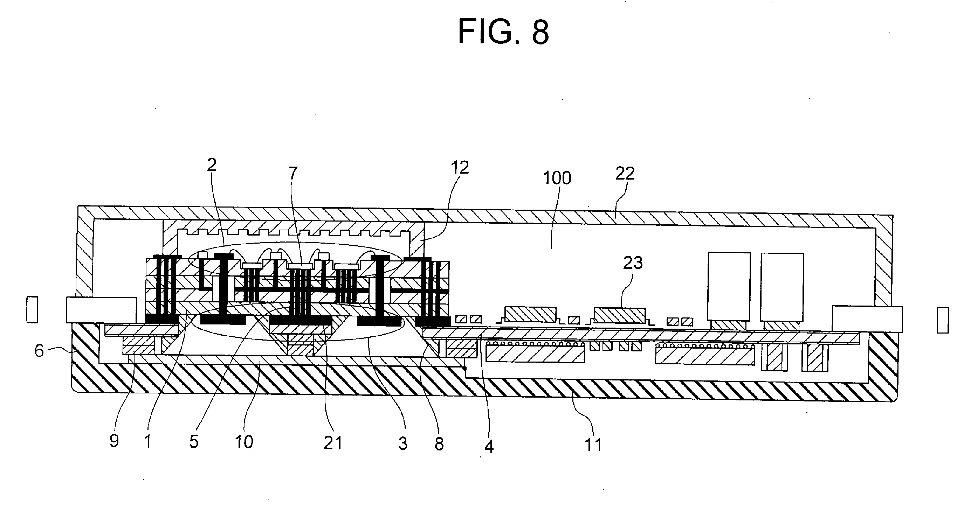

FIG. 8 shows a millimeter-wave radar 100 in accordance with a sixth embodiment of the present invention. The millimeter-wave radar 100 of the present embodiment includes at least a multilayer substrate 1, an RF circuit 2, an antenna 3, a heat transmitting plate 4, a via hole 5, a casing 6, an active circuit 7 in the RF circuit, a radio wave absorber 8, a support base 9, a polarizer 10, a radome 11, an RF circuit lid 12, and a lid heat transmitting plate 13. The RF circuit lid 12 and a casing back lid 22 of the millimeter-wave radar 100 are provided above the RF circuit 2. An adhesive 21 for increasing the adhesion between the multilayer substrate 1 and the heat transmitting plate 4 is also provided. An RF circuit control board 23 having a signal processing circuit for the radar (for RF circuit control) and a power supply circuit mounted thereon are also provided. The heat transmitting plate 4, which is a resin-based multilayer substrate, is provided to use a thick metallic conductor provided in the inner layer of the substrate as heat conductor. Since the heat transmitting plate 4 is a resin-based multilayer substrate, the plate has a signal processing circuit for RF circuit control and a power supply circuit on its front and back surfaces, and functions as the RF circuit control board 23. In order to lower the thermal resistance between the multilayer substrate 1 and the heat transmitting plate, a heat transmitting adhesive having a high adhesion or a conductive adhesive is used as the adhesive 21. When input and output terminals for controlling the RF circuit 2 are provided on the rear surface of the multilayer substrate 1 in the form of metallic projections, part of the adhesive 21 can be connected with a flip-flop or with the heat transmitting plate 4 or the RF circuit control board 23 with use of an anisotropic adhesive.

In the present embodiment, since the heat transmitting plate 4 is used also as the RF circuit control board 23, the millimeter-wave radar 100 (casing) can be made thin in thickness. Accordingly, when the radar is mounted in a vehicle, the radar can be mounted even in a location having a narrow radar installation space such as parts of the vehicle around its front side. Further, heat issued from the top of the RF circuit 2 tends to be easily escaped to outside the casing advantageously.

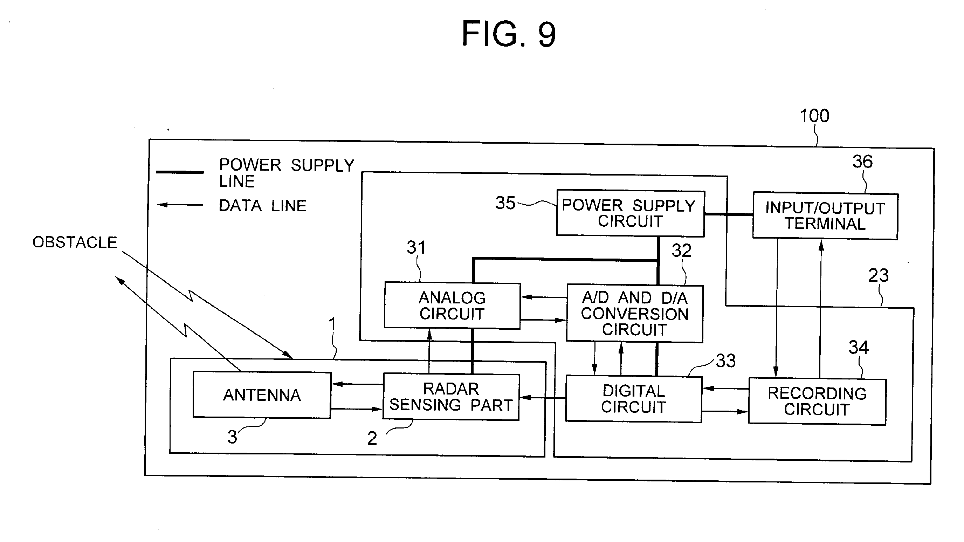

FIG. 9 is a block diagram of a millimeter-wave radar 100. The millimeter-wave radar 100 includes a multilayer substrate 1, an RF circuit control board 23, and an input/output circuit 36. The multilayer substrate 1 has an RF circuit 2 and an antenna 3. The RF circuit control board 23 has an analog circuit 31, an A/D (Analog to Digital) and D/A (Digital to Analog) conversion circuit 32, a digital circuit 33, a recording circuit 34, and a power supply circuit 35.

In the millimeter-wave radar 100, according to an operational program written in the recording circuit 34, the digital circuit 33 activates a CPU (Central Processing Unit) or a DSP (Digital Signal Processing), and the analog circuit 31 drives a radar sensing part of the RF circuit 2 through the A/D and D/A conversion circuit 32. The RF circuit 2 receives a reflected signal including a Doppler signal from the antenna 3, generates an intermediate frequency IF signal containing the Doppler signal, and transmits the IF signal to the analog circuit 31. The IF signal is amplified and waveform-shaped to a certain extent by the analog circuit 31, sampled by the A/D and D/A conversion circuit 32, and then processed by the digital circuit 33. The digital circuit 33, according to the program of the recording circuit 34, calculates a relative speed, a relative distance, a relative angle, and so on on the basis of a reflected wave from an obstacle. These calculated results are recorded in the recording circuit 34 and also transmitted externally from the input/output circuit 36.

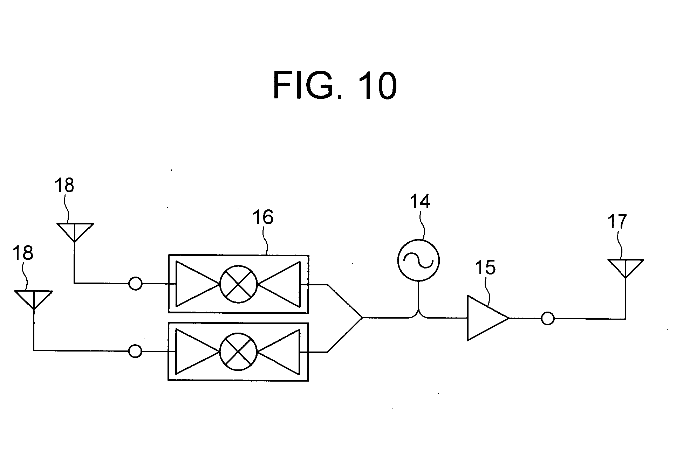

FIG. 10 shows a block diagram of the RF circuit 2. The RF circuit 2 for the radar, has an oscillator 14, a power amplifier 15, a receiver 16, a transmitting antenna 17, and a receiving antenna 18. A millimeter-wave signal generated by the oscillator 14 is transmitted (input) to the power amplifier 15 on the one hand and also to the receiver 16 on the other hand as an LO signal. The millimeter-wave signal input to the power amplifier 15 is amplified and radiated from the transmitting antenna 17. The millimeter-wave signal reflected by an obstacle is received at the receiving antenna 18 and then input to the receiver 16. The receiver 16 does mixdown on the LO signal of the reflected signal subjected to the Doppler effect, and extracts the reflected signal subjected to the Doppler effect as an intermediate frequency IF signal therefrom. The IF signal extracted by the receiver is transmitted to the signal processing circuit.

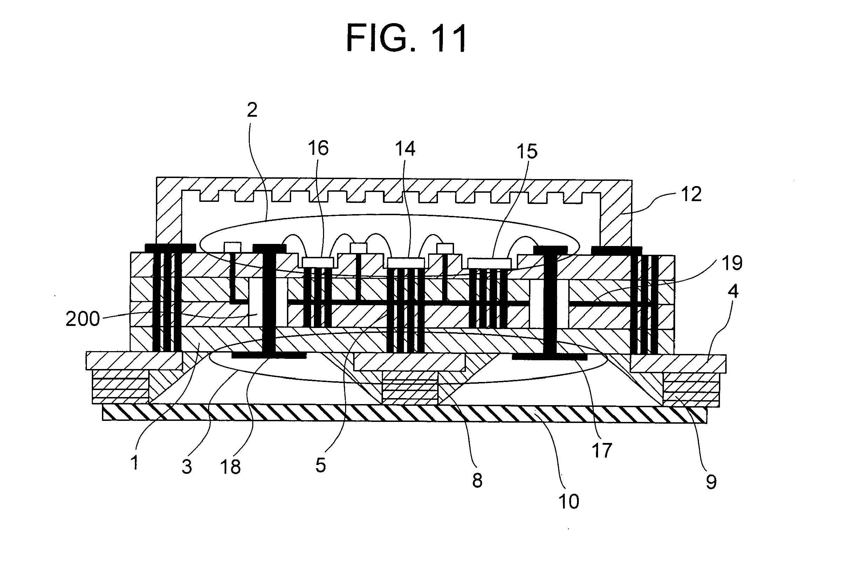

FIG. 11 shows a first detailed structure of the multilayer substrate 1. An active circuit positioned in the center of the RF circuit 2 is the oscillator 14, an active circuit positioned at the right side of the oscillator 14 is the power amplifier 15, and an active circuit positioned at the left side thereof is the receiver 16. The transmitting antenna 17 is provided at the right side of the antenna 3, and the receiving antenna 18 is provided at the left side thereof. Power and signal lines 19 are located in an inner layer of the multilayer substrate at a position intermediate between grounding metallic layers so as to avoid electric connection between the RF circuit 2 and the antenna. The power and signal lines 19 are connected to the RF circuit 2 through signal and power via holes. A drive signal controlled by the analog circuit 31 in FIG. 9 operates the RF circuit 2 through the power and signal lines 19. A DC signal of the power supply or the IF signal extracted by the receiver has a low frequency. Thus, even when such signal is transmitted via a wire, its signal loss is small.

The active circuits of the oscillator 14, the power amplifier 15, and the receiver 16 are mounted on the multilayer substrate 1 by soldering or with a conductive adhesive. When these active circuits 7 are mounted face-up, the millimeter-wave signal is transmitted to the transmission line of the multilayer substrate 1 via a bonding wire or ribbon line. As the transmission line of the millimeter-wave signal between the RF circuit 2 and the antenna 3, a pseudo coaxial line 18 using a via hole is used. The IF signal generated by the receiver 16 is again transmitted to the analog circuit 31 via the power and signal lines 19.

Although not shown, the active circuit can also be mounted on the multilayer substrate 1 in the form of a flip chip. In the case of the flip chip mounting, a multiplicity of bump metals are provided to increase the surface area of contact with the heat radiating via hole 5. Further, an active circuit having a small amount of heat generation is employed. When the active circuit is mounted in the form of a flip chip, a wire bonding step can be eliminated and thus its productivity can advantageously be increased.

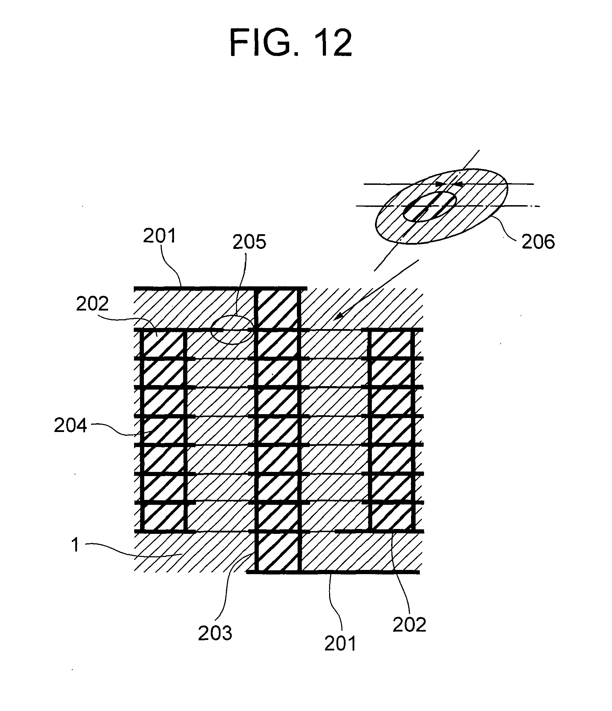

FIG. 12 shows a layout arrangement of a pseudo coaxial line 200. A microstrip line 201 as the transmission line for the RF circuit 2 and the antenna 3 is formed on each of the front and rear surfaces of the multilayer substrate 1, and a grounding metallic layer 202 as a counter electrode of the microstrip line is formed in an lower layer of each of the front and rear surfaces of the multilayer substrate. The pseudo coaxial line 200 is made up of a central conductor 203 of the via holes 5 connected in series, outer conductors 204 of the in-series-connected via holes 5 arranged cocentrically with the central conductor 203, an impedance adjusting gap 205 formed by the grounding metallic layer 202, and an escape land 206 formed by the grounding metallic layer 202. The microstrip line 201 is connected to the central conductor 203. However, to electrically separate the central conductor 203 from the outer conductors 204, the GND (grounding) metallic layer is connected to the outer conductor 204. Thus, part of the microstrip line 201 close to the counter grounding electrode is not present due to the impedance adjusting gap 205, and therefore the impedance value of the microstrip line is increased. In order to suppress the increase of the impedance value of the microstrip line 201, the impedance adjusting gap 205 is set not to be longer than a wavelength λ/4. An end of the grounding metallic layer 202 of the impedance adjusting gap 205 is set to be located at a position away by a wavelength of λ/4 or less from the center of the via hole 5 of the outer conductors 204. In order to concentrate the millimeter-wave signal of the microstrip line on the impedance adjusting gap 205, the center of the escape land 206 is shifted from the center of the central conductor 203 by a distance of a wavelength of λ/4 or less in a direction opposed to a microstrip line introduction direction.

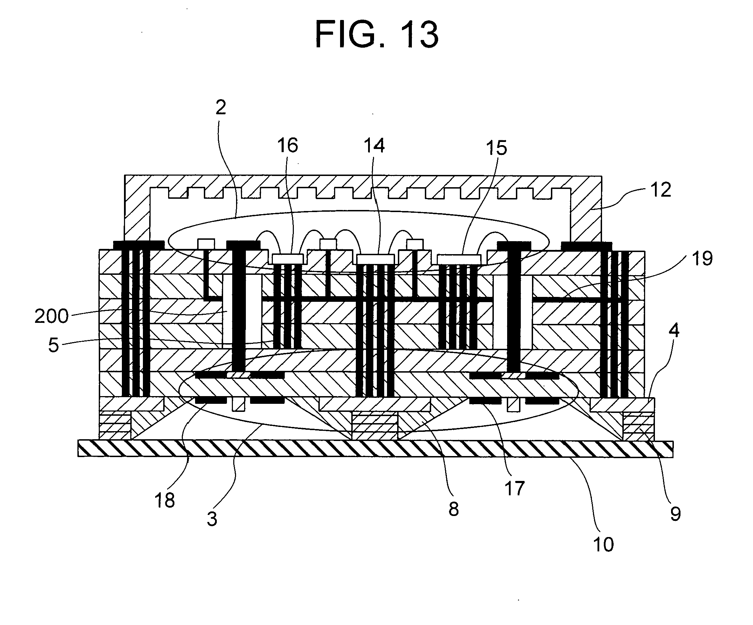

FIG. 13 is a second structure of the multilayer substrate 1. A line for supplying power to the antenna element is provided not on the rear surface of the multilayer substrate 1 but is provided in an intermediate layer of the multilayer substrate 1. A secondary radiation element for guiding a radio wave into a space is provided on the rear surface of the multilayer substrate. Since the antenna power supply line is moved from the rear surface of the multilayer substrate to the intermediate layer thereof, when an opening for the heat transmitting plate 4 is provided for each of such secondary radiation elements, the contact surface area between the heat transmitting plate 4 and the multilayer substrate 1 can be increased.

### Embodiment 7:

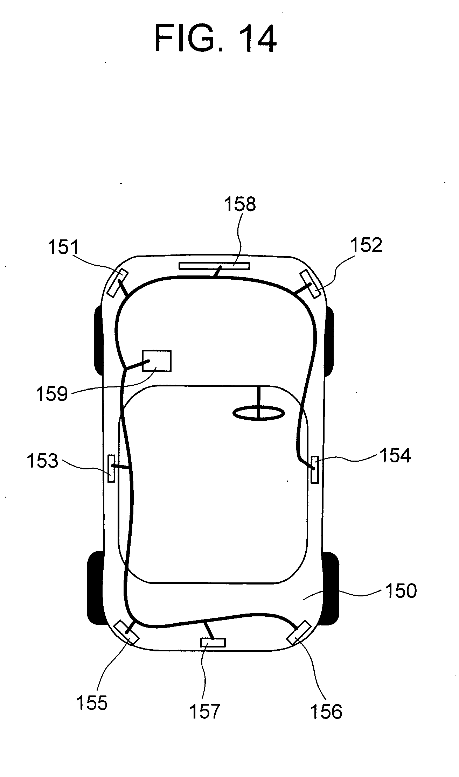

FIG. 14 shows a radar system 150 as an embodiment of the present invention. For the purpose of observing the surroundings of a vehicle, the radar system 150 includes a millimeter-wave radar for the left front direction 151, a millimeter-wave radar for the right front direction 152, a millimeter-wave radar for the left side direction 153, a millimeter-wave radar for the right side direction 154, a millimeter-wave radar for the left back direction 155, a right obliquely-backward millimeter-wave radar for the right back direction 156, a millimeter-wave radar for the back direction 157, a forward far-distance radar (or a doppler radar) 158, and a controller (or a radio control unit) 159 for monitoring and adjusting these radars. When the millimeter-wave radar having the heat radiating structure shown in FIGS. 1 to 13 is used, even installation of the radar in such a closed space as a sideview mirror tending to confine heat therein can realize the stable operation of the millimeter-wave radar, because the radar becomes higher than its ambient temperature but its temperature increase is slight. Since the operational reliability of the millimeter-wave radar is improved by the stable operation, even the radar system using a plurality of such millimeter-wave radars in a vehicle can be improved in its resistance to environment.

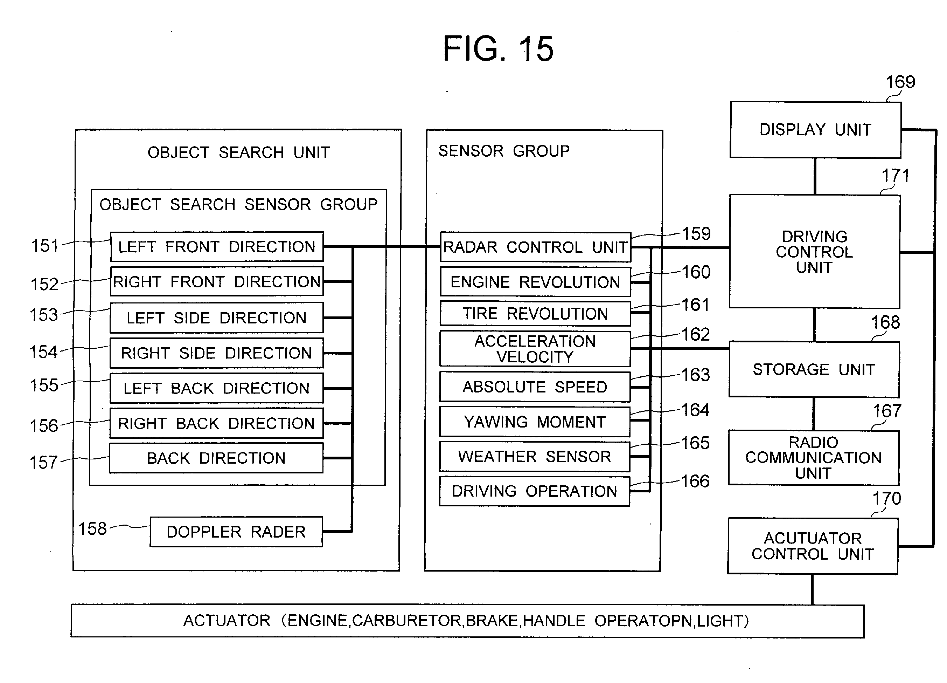

FIG. 15 is a vehicle control apparatus having the radar system of FIG. 14 built in a vehicle. In addition to the radar system, the vehicle control apparatus includes a engine revolution meter or tachometer 160, a tire revolution meter 161, an acceleration velocity sensor 162, a (absolute) speed sensor 163, a yawing moment sensor 164, a weather sensor 165 for temperature, humidity, etc., a driving operation sensor 166, a radio communication unit 167, a storage unit 168, a display unit 169, an actuator control unit 170 for controlling an engine, etc., and an actuator control unit (or a driving control unit) 171 for performing integrated control on the entire vehicle control apparatus. The vehicle control apparatus monitors in detail the ambient environment, the operational state of the vehicle, and weather by the sensor group, and acquires a road traffic state such as a traffic congestion state from the radio communication unit 167. Therefore, the vehicle control apparatus can offer always the best state to the vehicle by controlling the vehicle under control of the actuator control unit 170. The vehicle control apparatus can always grasp the vehicle driven state including a vehicle condition and a vehicle surrounding condition. Therefore, an accident can be easily analyzed or a car insurance fee can be easily calculated by tracing such a state in the storage unit.

As has been explained in the foregoing, in accordance with the respective embodiments of the present invention, heat generated in the active circuits of the RF circuit provided on the front surface of the multilayer substrate can be transmitted to the rear side of the substrate through the via holes, further from the heat transmitting plate to the casing, and externally radiated from the mount part of the casing. The heat transmitting plate and the oscillator as a key to the stable operation of the millimeter-wave radar are connected with the shortest distance therebetween with the multilayer substrate disposed therebetween, its thermal resistance can be advantageously reduced. Further, when the wave radiation characteristic of the antenna is improved with use of the radio wave absorber and the polarizer by suppressing the inter-antenna interference, diffracted waves, and the cross polarized waves of the antenna, the position of the obstacle can be accurately measured. In addition, when the radome is used, even a resistance to environment can also be improved, and the reliability of the millimeter-wave radar in addition to the temperature characteristic thereof can be improved.

With the arrangement of providing the RF circuit and the antenna on the front and rear surfaces of the multilayer substrate, when an opening is provided in the heat transmitting plate according to the radiation characteristic of the antenna, the multilayer substrate and the heat transmitting plate can also be made small even when the substrate and the plate are laminated or mounted each other. Thus the miniaturization of the millimeter-wave radar can be realized while maintaining the radiation characteristic. For this reason, even when the millimeter-wave radar of a light weight having a small shape and an improved temperature characteristic is provided in a small-sized closed space such as a door mirror, the radar can stably scan.

As a result, the radar system using a plurality of the millimeter-wave radars can easily grasp environmental conditions outside of a car on a real-time basis. In other words, there are provided car obstacle monitoring sensors which can provide many surrounding situations to the driver in every driving operation of congestion drive, cornering, route change drive, etc. and can prevent a car accident beforehand.

The apparatus can grasp driver's driving pattern in the surrounding environment. That is, there are provided car obstacle monitoring sensors which can statistically derive a safe drive index to the driving. Thus on the basis of the derived safe drive index, driver's car insurance fee can be reduced or a decision to an actual accident can be made from objective view.

It should be further understood by those skilled in the art that although the foregoing description has been made on embodiments of the invention, the invention is not limited thereto and various changes and modifications may be made without departing from the spirit of the invention and the scope of the appended claims.

The above mentioned features and embodiments may be combined in any way, partly or as a whole.

## Claims

1. A millimeter-wave radar apparatus (100) comprising:
a multilayer substrate (1) made of a plurality of stacked layers;
an active circuit (7) provided on a first surface of the multilayer substrate (1);
an antenna (3) provided on a second surface of said multilayer substrate opposed to said first surface thereof for radiating an electric signal of millimeter-wave generated by said active circuit in the form of an electromagnetic wave; and
a first heat transmitting plate (4) provided on said second surface for externally radiating heat generated in said active circuit,
wherein said antenna (3) is electrically connected with said active circuit via a first via hole (5) formed to pass through at least part of said multilayer substrate defined by said first and second surfaces thereof when viewed as alternating current circuit, and said heat transmitting plate (4) is formed to pass through at least part of said multilayer substrate defined by the first and second surfaces thereof and also is thermally connected with said active circuit via a second via hole formed as a via hole different from said first via hole (5).

2. The millimeter-wave radar apparatus (100) according to claim 1, wherein said active circuit (7). and said heat transmitting plate (4) are positioned so that heat generated in said active circuit is transmitted to said heat transmitting plate with a shortest route through said second via hole.

3. The millimeter-wave radar apparatus (100) according to claim 10 or 2, wherein said active circuit (7) and said first heat transmitting plate (4) are thermally connected commonly by a plurality of said second via holes.

4. The millimeter-wave radar apparatus (100) according to claim 10 or 2, wherein said heat transmitting plate (4) has an opening through which said antenna (3) is exposed, said antenna is located in a region of said second surface at a position corresponding to said opening, and a radio wave absorber (4) is provided to straddle the opening of said heat transmitting plate (4) and a part of the heat transmitting plate other than said opening.

5. The millimeter-wave radar apparatus (100) according to at least one of claims 1 to 4, wherein said radio wave absorber (8) has a tapered shape.

6. The millimeter-wave radar apparatus (100) according to at least one of claims 1 to 5, wherein said radio wave absorber (8) contains a material impregnated with powder for absorbing an electromagnetic wave.

7. The millimeter-wave radar apparatus (100) according to at least one of claims 1 to 6, wherein said radio wave absorber (8) contains a material impregnated with powder of at least one of sorts of carbon, graphite, silicon carbide, and carbon nanotube.

8. The millimeter-wave radar apparatus (100) according to at least one of claims 1 to 7, further comprising a casing (6) for fixing said multilayer substrate (1), wherein said multilayer substrate is fixed to said casing through said first heat transmitting plate (4), and a heat radiation path of externally radiating heat from said heat transmitting plate through a plurality of holes provided in said casing is secured.

9. The millimeter-wave radar apparatus (100) according to at least one of claims 1 to 7, further comprising a casing (6) for fixing said multilayer substrate (1), wherein said first heat transmitting plate is formed integrally with said casing, and a heat radiation path of externally radiating heat from said heat transmitting plate through a plurality of holes provided in said casing is secured.

10. The millimeter-wave radar apparatus (100) according to at least one of claims 1 to 9, wherein said first heat transmitting plate (4) and said multilayer substrate (1) are mutually bonded by means of at least one of using a heat transmitting adhesive or a conductive adhesive, flip-chip bonding, and using an anisotropic adhesive.

11. The millimeter-wave radar apparatus (100) according to at least one of claims 1 to 10, wherein said multilayer substrate (1) and said heat transmitting plate (4) are mutually bonded by means of at least one of flip-chip bonding and using an anisotropic adhesive, and said via hole is used also as an input/output terminal.

12. The millimeter-wave radar apparatus (100) according to at least one of claims 1 to 11, wherein said heat transmitting plate (4) includes a heat transmitting metallic conductor.

13. The millimeter-wave radar apparatus (100) according to at least one of claims 1 to 12, wherein said heat transmitting plate (4) contains a resin, and at least one of a signal processing circuit and a power supply circuit for a millimeter-wave radar is mounted on said heat transmitting plate.

14. The millimeter-wave radar apparatus (100) according to at least one of claims 1 to 4, further comprising a polarizer (10) for suppressing interference of a cross polarized wave, wherein said polarizer is provided on a side of said radio wave absorber (8) opposed to said multilayer substrate (4) with said absorber disposed between said multilayer substrate and said polarizer.

15. The millimeter-wave radar apparatus (100) according to at least one of claims 1 to 14, further comprising a radome (11) located on a side of said radio wave absorber (8) opposed to said multilayer substrate (1) with said radio wave absorber disposed between said multilayer substrate and said radome for covering said entire multilayer substrate, and when λ denotes a wavelength of said electromagnetic wave radiated from said antenna (3), a thickness of said radome is substantially equal to an integral multiple of λ/2.

16. The millimeter-wave radar apparatus (100) according to at least one of claims 1 to 15, further comprising a casing (6) for fixing said multilayer substrate (1), wherein said radome (11) is fixed to said casing.

17. The millimeter-wave radar apparatus (100) according to at least one of claims 1 to 16, wherein said active circuit (7) and said antenna (3) are electrically connected by a microstrip line (201) and said first via hole (5) when viewed as an A.C. circuit, said first via hole acts as a pseudo coaxial line by a plurality of via holes formed so as to pass through at least part of said multilayer substrate (1), and when λ denotes a wavelength of said millimeter-wave radiated from said antenna, a metallic conductive layer as a counter electrode of said microstrip line (201) is arranged in the form of a landless gap pattern with a gap of λ/4 or less from a central conductor of the via hole of said pseudo coaxial line.

18. The millimeter-wave radar system (150) for observing an obstacle to a vehicle, said system comprising a millimeter-wave radar apparatus (100) arranged to be mounted in said vehicle, said millimeter-wave radar apparatus comprising:
a multilayer substrate (1) made of a plurality of overlapped layers;
an active circuit (7) provided on a first surface of said multilayer substrate;
an antenna (3) provided on a second surface of said multilayer substrate opposed to said first surface for radiating a millimeter-wave electric signal generated by said active circuit as an electromagnetic wave; and
a first heat transmitting plate (4) provided on said second surface for externally radiating heat generated in said active circuit,
wherein said antenna is electrically connected to said active circuit through a first via hole (5) formed so as to pass through at least part of said multilayer substrate between said first and second surfaces when viewed as an A.C. circuit, said heat transmitting plate is formed so as to pass through at least part of said multilayer substrate between said first and second surfaces and is thermally connected to said active circuit through a second via hole formed differently from said first via hole.

19. The millimeter-wave radar system (150) according to claim 18, wherein said active circuit (7) and said heat transmitting plate (4) are positioned so that heat generated in said active circuit is transmitted to said heat transmitting plate with a shortest route through said second via hole.

20. The millimeter-wave radar system (150) according to claim 18 or 19, wherein said active circuit (7) and said first heat transmitting plate (4) are thermally connected commonly by a plurality of said second via holes.
